# EUROPEAN PATENT APPLICATION

(11) **EP 4 521 773 A1**
(43) Date of publication of application: **12.03.2025**
(21) Application number: 23196027.9
(22) Date of filing: 07.09.2023
(51) Int. Cl.: H04R 1/10, H04R 25/00, B29C 33/38

(54) **SKELETON HOUSING AND METHOD FOR TAKING AN EAR IMPRESSION**

(71) Applicant: Sonova AG, 8712 Stäfa (CH)
(72) Inventor: LEUTHOLD, Markus, 8712 Stäfa (CH); GUNDE, Petra, 8633 Wolfhausen (CH); SEITERLE, Stefan, 8057 Zürich (CH); GUILLON, Pierre, 8712 Stäfa (CH)
(74) Representative: Liedtke & Partner Patentanwälte

(57) **Abstract**

The invention relates to a skeleton housing (1) for taking an ear impression (20) of a part of an ear canal (14) of a human ear (10), the skeleton housing (1) having a shape fitting into a concha (11) of the ear (10), the skeleton housing (1) comprising a hollow permeable shell permitting a viscous impression material to flow through, the skeleton housing (1) comprising a medial opening (3) positioned to face toward or into the ear canal (14) when the skeleton housing (1) is inserted in the concha (11). Moreover, the invention relates to a method of producing an ear impression (20) using the skeleton housing and to a method of producing a customized extension (40) such as an ear tip.

## Description

### Technical Field

The invention relates to a skeleton housing and a method for taking an ear impression as well as a method for producing a customized extension such as a custom ear tip configured to be coupled to a housing of a concha worn device, e.g. a hearing device.

### Background of the Invention

Non-custom concha worn devices such as smart earphones (also referred to as hearables) or hearing aids (one-size fits all devices) need to be coupled to the ear in a way to ensure acoustic sealing. In particular concha worn devices configured for active noise cancelling (ANC) rely on a good acoustic sealing. Acoustic sealing also reduces feedback loop issues for devices with a short feedback path such as hearables.

Moreover, concha worn devices need to be reliably retained in place. Hearables are heavier than traditional hearing instruments and hence more prone to losing the device during body movement or chewing.

Further, hearables or hearing instruments are expected to be worn for many hours, so they should not apply uncomfortable pressure points.

Moreover, the acceptance of the concha worn device is higher if it fits nicely and flush into the concha and does not protrude too much.

It is known in the art to try to accomplish these requirements with a dome made of soft material, such as silicone or memory foam. Due to the one-size-fits-all nature of the concha worn device and the high variation of ear morphologies, the dome approach can fail to reach an acceptable compromise of sealing, retention, wearing comfort and aesthetics with just a few dome sizes.

A possible solution to solve this could be a custom coupling by means of traditional impression taking or direct ear scanning, followed by a CAD like digital ear mold modeling and 3D printing. While the traditional approach allows to generate a wellshaped custom mold, the relative location between device and custom ear mold only relies on guessing.

### Summary of the Invention

It is an object of the present invention to provide a novel solution suitable for producing a customized extension such as an ear tip or ear fin configured to be coupled to a housing of a concha worn device such as a hearing device, the concha worn device fitting into a concha of a human ear.

The object is achieved by a skeleton housing according to claim 1, by a method for producing an ear impression according to claim 8 and by a method for producing a customized extension such as an ear tip according to claim 12.

Preferred embodiments of the invention are given in the dependent claims.

The term lateral as used herein refers to a direction generally away from a user's body whereas the term medial refers to the opposite direction.

According to the invention, a skeleton housing for taking an ear impression of a part of an ear canal and/or of at least a part of a concha of a human ear is proposed, the skeleton housing having a shape fitting into a concha of the ear, the skeleton housing comprising a hollow permeable (or porous) shell permitting a viscous impression material to flow through, the skeleton housing comprising a medial opening positioned to face toward or into the ear canal when the skeleton housing is inserted in the concha.

The impression material may be the same impression material as used in traditional impression taking for producing a custom mold for an ear canal or a so called ear canal bridge.

In an exemplary embodiment the hollow shell is configured as a grid or basket having loops or openings or is made from a permeable (or porous) material permitting a viscous impression material to flow through.

In an exemplary embodiment, the skeleton housing further comprises a lateral opening positioned to face in a lateral direction.

In an exemplary embodiment, the lateral opening and/or the medial opening may be larger than any other openings in the permeable shell. In other embodiments, the medial opening may be smaller than the openings in the permeable shell or equal in size.

In an exemplary embodiment, the skeleton housing may be shaped to slightly deform the concha when inserted therein. In other embodiments, the skeleton housing may not deform the concha.

In an exemplary embodiment, a shape of the skeleton housing resembles the shape of a housing of a concha worn device such as a hearing device having a spout fitting into the medial opening. The form of the medial opening of the skeleton housing is chosen such that it may encompass the spout.

In an exemplary embodiment, the medial opening is larger than the spout in order to reserve space for the wall thickness of the custom tip.

In an exemplary embodiment, the hollow shell is configured to be permeable at least almost entirely or only adjacent the medial opening and has a closed surface otherwise except for the lateral and/or medial openings.

According to an aspect of the present invention, a method of producing an ear impression using a skeleton housing, in particular the skeleton housing described above, is proposed, the method comprising the steps of:
A) inserting the skeleton housing into a concha of a human ear such that the medial opening faces toward or into an ear canal of the ear, e.g. in a medial direction,
B) injecting an impression material into the ear canal to fill up the ear canal towards the concha (optionally, the concha may also be at least partially filled),
C) curing the impression material to form the ear impression at least partially embedding the skeleton housing, comprising an ear canal and a housing portion at least partially embedding the skeleton housing,
D)removing the ear impression with the skeleton housing from the ear.

The amount of impression material filled in may be chosen to be sufficient to at least partially embed the skeleton housing.

Curing may denote simply waiting for some time and letting the impression material cure this way. In other embodiments, curing may comprise application of at least one curing agent.

The skeleton housing may further comprise a lateral opening which may face in the lateral direction when the skeleton housing is inserted into the concha.

The impression material may further be filled in through the lateral opening into the skeleton housing, wherein the impression material may be filled through the medial opening and the adjacent permeable shell.

The ear canal portion may include those parts of the impression material which have flowed out of the medial opening and the adjacent permeable shell into the ear canal.

In an exemplary embodiment, step A may be performed before step B and injecting the impression material is carried out through a lateral opening or the lateral opening of the skeleton housing into the skeleton housing, wherein the impression material flows through the medial opening and the adjacent permeable shell, or wherein injecting the impression material is carried out through the lateral opening and the medial opening.

In another exemplary embodiment, step B may be performed before step A.

In an exemplary embodiment, a protrusion on the skeleton housing may be placed between the tragus and antitragus of the ear when the skeleton housing is inserted in the concha.

In an exemplary embodiment, the supply of impression material is stopped when the impression material has filled the ear canal, e.g. through the medial opening, and backlogs in the concha and/or in the skeleton housing or even outside the lateral opening.

In an exemplary embodiment, the ear canal is filled with the impression material beyond the first bend.

According to an aspect of the present invention, a method of producing a customized extension such as an ear tip configured to be coupled to a housing of a concha worn device such as a hearing device is proposed, the housing having a shape fitting into a concha of a human ear, the customized extension having a shape fitting into an ear canal of the ear, the method including one of the methods of producing an ear impression described above and further comprising the steps of:
- 3D-scanning the ear impression with the embedded skeleton housing,
- registering the 3D-scanned ear impression and the embedded skeleton housing with a 3D geometry of the housing having a spout in a modelling software, such that the spout is registered with the medial opening,
- modelling the customized extension to resemble the shape of the ear canal portion of the ear impression and to comprise a connector positioned and oriented to couple to the spout.

In another embodiment, an alternative or additional customized extension may be provided as an ear fin configured to fit into the cavum cymba portion of the ear. In another embodiment, an alternative or additional customized extension may be provided as an extension of the standard concha worn device configured to fit anywhere in-between the housing of the concha worn device and the ear skin surface. In order to produce such an alternative customized extension, the skeleton housing may comprise another opening pointing in the direction in which the extension is supposed to extend from the housing instead of into the ear canal and the impression material may have to be filled into said portion of the ear through said opening.

In an exemplary embodiment, the customized extension is made of a soft material having a Shore A hardness of at most 30 or 40. In other embodiments, the customized extension may be made of a hard material such as titanium, acrylic, polyurethane or any other material suitable for eartips. If a hard material is used, an additional soft connector may be applied to attach the customized extension to the housing of the concha worn device, e.g. an earbud.

In an exemplary embodiment, the connector has a circular or oval cross section in order to be connected to the spout having a circular or oval cross section.

According to another aspect of the invention, a hearing device is proposed, comprising a housing with a spout and a customized extension as described above coupled to the spout.

Further scope of applicability of the present invention will become apparent from the detailed description given hereinafter. However, it should be understood that the detailed description and specific examples, while indicating preferred embodiments of the invention, are given by way of illustration only, since various changes and modifications within the spirit and scope of the invention will become apparent to those skilled in the art from this detailed description.

The customized extension of the concha worn device may provide improved comfort, acoustical sealing, aesthetics and/or retention.

### Brief Description of the Drawings

The present invention will become more fully understood from the detailed description given hereinbelow and the accompanying drawings which are given by way of illustration only, and thus, are not limitative of the present invention, and wherein:
- Figure 1: is a schematic view of a concha and an ear canal of a human ear when taking an ear impression according to the prior art,
- Figure 2: is a schematic view of the concha and the ear canal with a housing of a concha worn device located in the concha and a customized extension such as an ear tip located in the ear canal,
- Figure 3: is a schematic view of the concha and the ear canal with a housing of a concha worn device located in the concha in another position and a customized extension such as an ear tip located in the ear canal,
- Figure 4: is a schematic view of the concha and the ear canal with a housing of a concha worn device located in the concha in yet another position and a customized extension such as an ear tip located in the ear canal,
- Figure 5: is a schematic view of a permeable skeleton housing imitating a housing of a concha worn device configured to fit into the concha of a user's ear,
- Figure 6: a schematic view of the skeleton housing positioned to fit in the concha of a user's ear,
- Figure 7: is a schematic view of the skeleton housing inserted in the user's ear, wherein the impression material is injected through the skeleton housing,
- Figure 8: is a schematic view of the skeleton housing inserted in the user's ear with the impression material having been injected to fill the ear canal and part of the skeleton housing to form an ear impression,
- Figure 9: is a schematic view of an ear impression with the skeleton housing,
- Figure 10: is a schematic view of aligned models of a real housing of a concha worn device and the skeleton housing,
- Figure 11: is a schematic view of a real housing of a concha worn device with a spout pointing into an ear canal of a user's ear with a customized extension such as an ear tip coupled to the spout,
- Figure 12: is a schematic view of a concha worn device arranged in a concha of an ear.

Corresponding parts are marked with the same reference symbols in all figures.

### Detailed Description of Preferred Embodiments

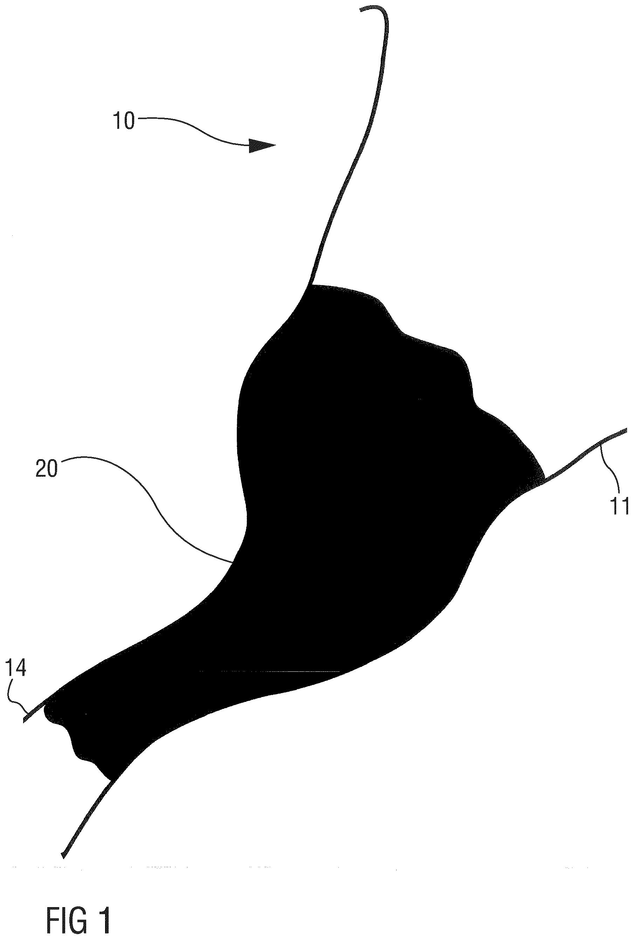

**Figure 1** is a schematic view of a concha 11 and an ear canal 14 of a human ear 10 when taking an ear impression 20 according to the prior art by pouring a viscous impression material into the ear 10. In this case, the concha 11 and ear canal 14 are generally not significantly deformed.

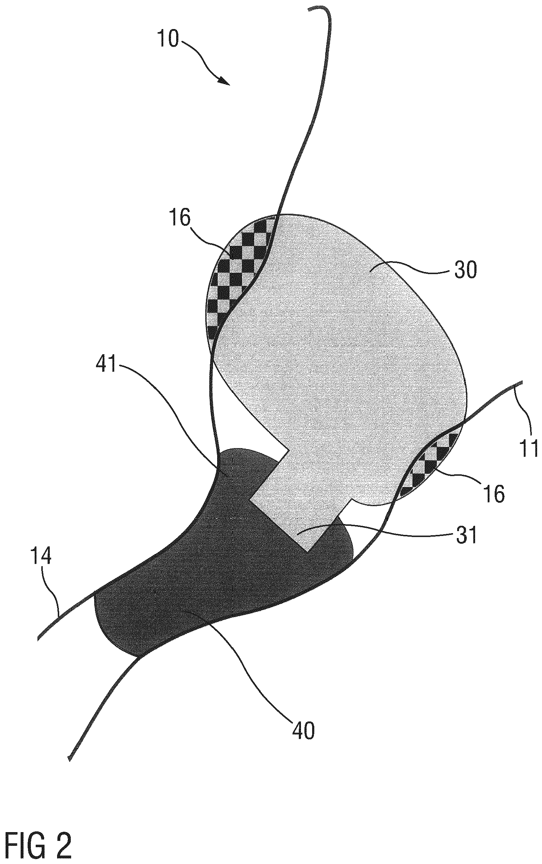

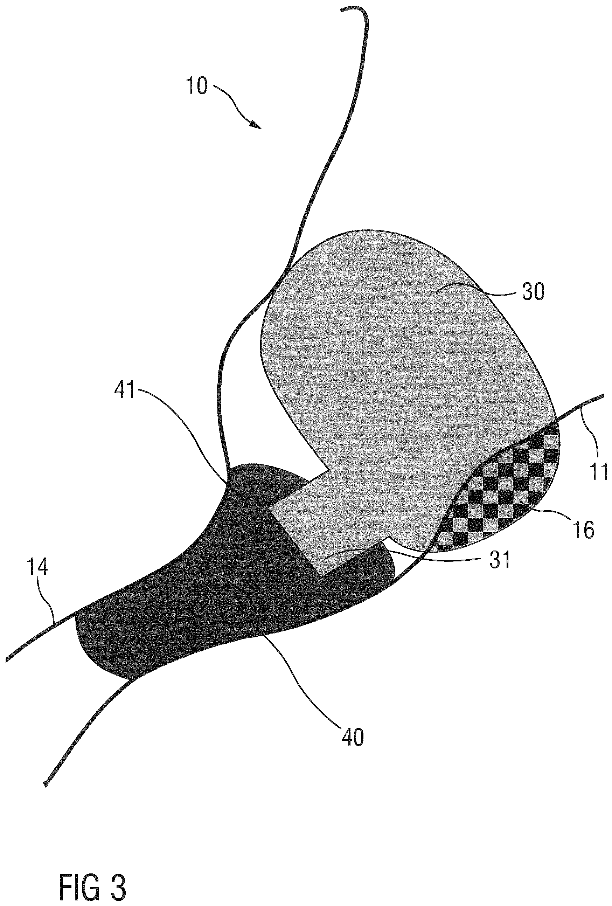

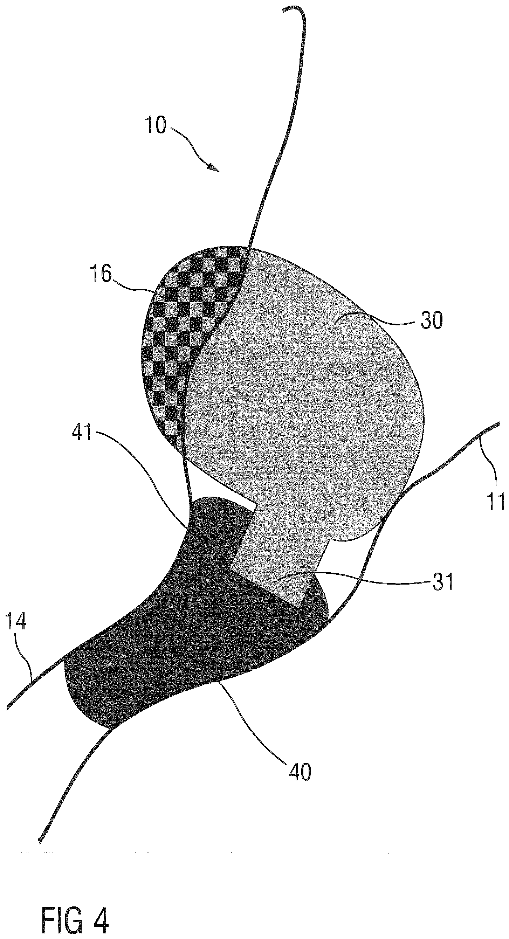

**Figure 2** is a schematic view of the concha 11 and the ear canal 14 with a housing 30 of a concha worn device such as a hearing device located in the concha 11 and a customized extension such as an ear tip 40 having a connector 41 located in the ear canal 14, wherein the connector 41 is coupled to a spout 31 of the housing 30. If the housing 30 is larger than the concha 11, the concha 11 can be locally deformed, e.g. at the shown positions 16. However, the deformation and the resulting position and orientation of the housing 30 in the concha 11 can just be guessed by an operator of a 3D modelling software: The operator is only presented with two rigid shapes, but he misses the actual softness of the ear as well as the wearing comfort of the inserted device at the chosen position. **Figures 3** **and** **4** show further, similar schematic views with different estimated deformations of the concha 11 and resulting positions and orientations of the housing 30 in the concha 11. As these estimates do not sufficiently well reflect the reality in the ear, the proper relative position of the customized extension 40 and its connector 41 with regard to the housing 30 and its spout 31 cannot be reliably determined either. When producing a customized extension 40 based on these estimates by the modelling software, this may result in a non-optimal relative position of the customized extension 40 and its connector 41 with regard to the housing 30 and its spout 31 and hence uncomfortable pressure points to the user's ear, inadequate hold and/or retention of the device and inadequate aesthetics.

In order to address this, the following solution is proposed:

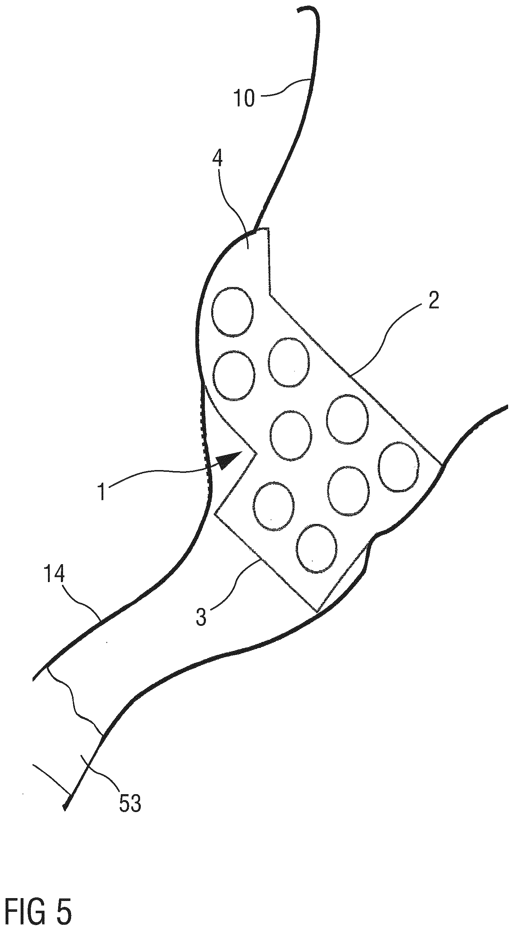

**Figure 5** is a schematic view of a skeleton housing 1 imitating the housing 30 of the concha worn device, inserted in a user's ear 10, wherein the skeleton housing 1 does not have a coupling, e.g. a dome, to the ear canal 14 of the user's ear 10.

The shape of the skeleton housing 1 corresponds in large parts to the housing 30 of an actual concha worn device. The skeleton housing 1 is configured as a hollow permeable skeleton shell which is permeable for a viscous impression material at least in the area where the customized extension will be connected to the housing of the concha worn device. The skeleton housing shape could be designed in the form of a grid or basket (having loops) or by having openings in general, permitting the viscous impression material to flow through when being filled into the skeleton housing 1. In order to facilitate filling the impression material in, the skeleton housing 1 may comprise a lateral opening 2 facing in a lateral direction, i.e. away from the user or out of the ear 10, when the skeleton housing 1 is inserted in the user's concha 11.

Moreover, the skeleton housing 1 comprises a medial opening 3 facing toward the ear canal 14 or in a medial direction when the skeleton housing 1 is inserted in the user's concha 11. The medial opening 3 is configured to allow the impression material to flow into the ear canal 14 when the impression material is filled into the skeleton housing 1. The lateral opening 2 and/or the medial opening 3 may be larger than any other openings in the skeleton housing. In other embodiments, the lateral opening 2 and/or the medial opening 3 may be smaller than the openings in the permeable shell or equal in size.

After applying the impression material, the skeleton housing 1 is partially embedded in the cured impression material, such that there is a rigid connection between skeleton housing 1 and ear impression 20.

The impression material may be filled in by placing a nozzle of a syringe containing the impression material through the lateral opening 2 and optionally through the medial opening 3 or the adjacent permeable shell into the ear canal to fill up the ear canal towards the concha displacing the impression material from the syringe. With proceeding filling of the ear canal, the syringe can be retracted to fill the skeleton housing as well. Optionally, the concha may also be at least partially filled.

The skeleton housing 1 is enlarged at the position of the medial opening 3, relative to the real housing 30 of the concha worn device which has the spout 31 at that position, to ensure sufficient clearance for the connector 41 of the customized extension 40 to be manufactured in the process. This ensures at least enough space for the wall thickness of the customized extension 40.

The skeleton housing 1 may be configured with openings, e.g. as a grid, almost entirely as shown in figure 5. In other embodiments, the skeleton housing 1 may be configured with openings, e.g. as a grid, only near the medial opening 3 and have a closed surface otherwise. This ensures that the impression material can enter and fill the ear canal 14. The entire skeleton housing 1 or the greater part thereof configured with openings, e.g. as a grid, may improve the form fit between the impression material and the skeleton housing 1.

Moreover, the skeleton housing 1 may comprise a protrusion 4 shaped and positioned to fit between the tragus 12 and antitragus 13 of the user's ear 10.

A positioning of the housing 30 in the deformed ear 10, which fulfils optimal wearing comfort, hold and/or retention and esthetical aspects, is determined by placing the skeleton housing 1 into the ear 10. Since the skeleton housing 1 does not contain any coupling, i.e. no dome, the positioning is not limited by the ear coupling, but only determined by the basically non-deformable skeleton housing 1. Therefore, the ear impression 20 is taken with the optimal or desired position of the skeleton housing 1 in the ear 10 with respect to wearing comfort, hold and/or retention and aesthetics. In this position, the customized extension 40 manufactured in the process using data acquired from the ear impression 20 will not apply uncomfortable pressure points to the user's ear 10.

The impression taking may follow best practice, known in the hearing instrument industry, e.g. the ear canal 14 may be checked with an otoscope, and a foam block 53 may be placed into the ear canal 14 to limit the flow of impression material in the medial direction.

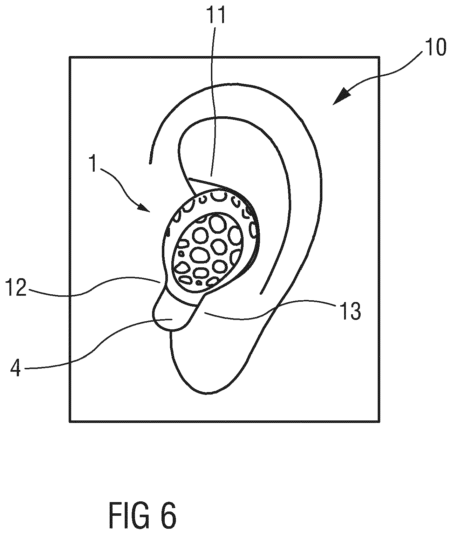

**Figure 6** is a schematic view of the skeleton housing 1 positioned to fit in the concha 11 of the user's ear 10, the protrusion 4 placed between the tragus 12 and antitragus 13 of the ear 10, wherein the lateral opening 2 faces in the lateral direction. The medial opening 3 (not visible in figure 6) protrudes toward or slightly into the ear canal 14 (not visible in figure 6).

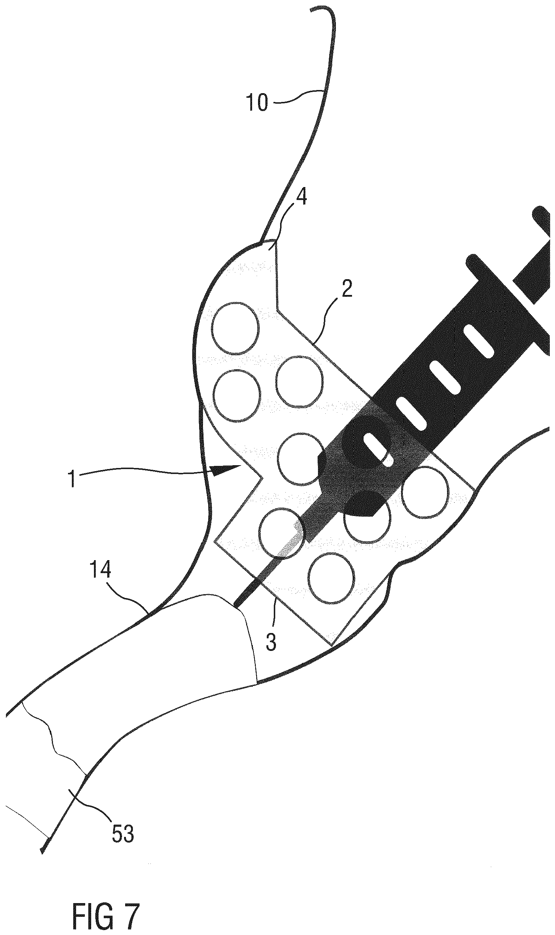

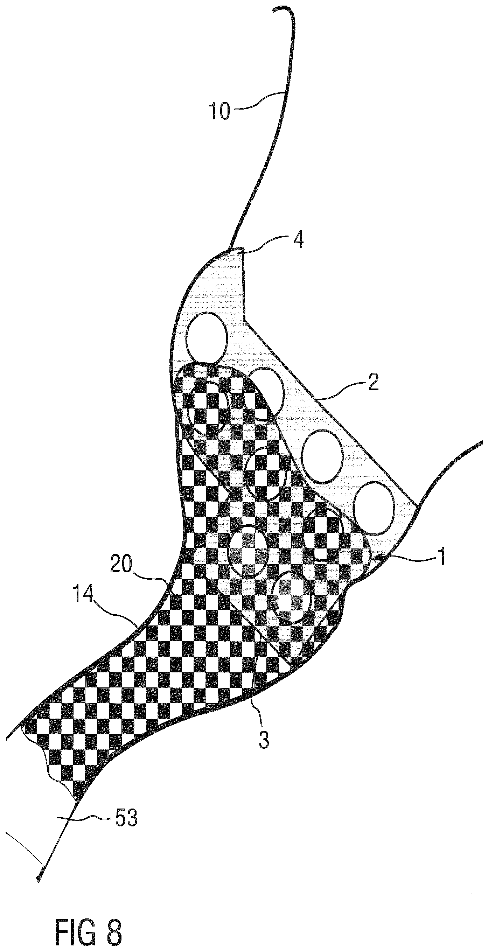

**Figure 7** is a schematic view of the skeleton housing 1 inserted in the user's ear 10, wherein the impression material is injected through the correctly placed skeleton housing 1, e.g. using a syringe. Once the still viscous impression material covers a large enough portion of the skeleton housing 1, the injection of impression material can be stopped. **Figure 8** is a schematic view of the skeleton housing 1 inserted in the user's ear 10 with the impression material having been injected to fill the ear canal 14 and part of the skeleton housing 1 and optionally part of the concha to form an ear impression 20. For example, the supply of impression material may stop when the impression material has filled the ear canal 14 through the medial opening 3 and backlogs in the skeleton housing 1 or even outside the lateral opening 2.

In another embodiment, the ear impression 20 may be produced using the skeleton housing 1 in a slightly different way, comprising the steps of:
- injecting the impression material into the ear canal 14 to fill up the ear canal 14 towards the concha 11 and optionally to at least partially fill up the concha 11,
- inserting the skeleton housing 1 into the still uncured or liquid impression material within the ear canal 14 and optionally the concha 11 such that the medial opening 3 faces toward or into the ear canal 14,
- curing the impression material to form the ear impression 20 at least partially embedding the skeleton housing 1.

In this case, the skeleton housing 1 does not necessarily have to comprise the lateral opening 2, although the method also works with a lateral opening 2.

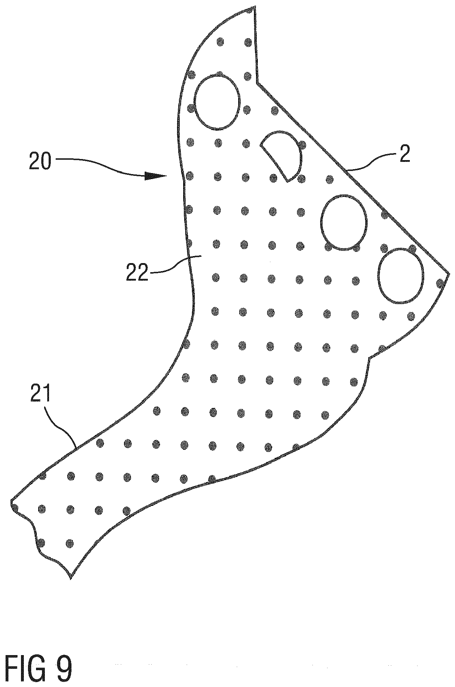

Once cured, the combo of skeleton housing 1 and ear impression 20 is removed from the ear and 3D scanned. **Figure 9** is a schematic view of the ear impression 20 with the skeleton housing 1. The ear impression 20 comprises an ear canal portion 21 having the shape of a part of the user's ear canal 14, wherein the ear canal portion 21 comprises those parts of the cured impression material which have flowed into the ear canal 14, e.g. out of the medial opening 3 and the adjacent openings, e.g. in the grid, of the skeleton housing 1 into the ear canal 14. Moreover, the ear impression 20 comprises a skeleton housing portion 22 at least partially embedding the skeleton housing 1. A further portion of the ear impression 20 which may exist outside the lateral opening 2 due to overfill is redundant and may not be needed in the further process. Later in the process, the shape of the ear canal portion 21 will be used to form a customized extension 40 with a connector 41 configured to be connected to the housing 30 of the concha worn device which resembles the shape of the skeleton housing 1.

The 3D scanned combo of skeleton housing 1 and ear impression 20 may be registered with a 3D skeleton housing geometry in the modelling software.

The position and orientation of the 3D device geometry is then implicitly given in the modelling software due to the known relative orientation of the skeleton housing 1 and the real housing 30 of the concha worn device. As a result, the position and orientation of the connector 41 of the customized extension 40 to the real housing 30 of the concha worn device are now defined.

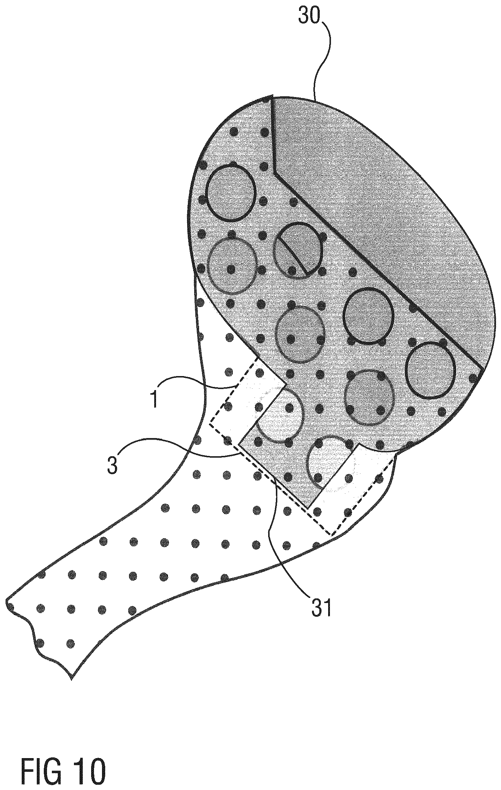

**Figure 10** is a schematic view of how the skeleton housing 1 is derived from the real housing 30. The skeleton housing 1 resembles the real housing 30 where the skeleton housing 1 is likely to be in contact with the skin. At the position of the medial opening 3 of the skeleton housing 1, the real housing 30 has the spout 31 as an interface to the connector 41 of the customized extension 40.

The customized extension 40 may then be modelled following best practice in hearing instrument industry, given the connector 41 position and orientation. For example, the customized extension 40 may provide a retention lock by reaching around the first bend 15 in the ear canal 14, ensuring optimal wearing comfort and retention and/or hold in the ear.

The customized extension 40 may be produced using standard custom mass manufacturing procedures, e.g. 3D printing, post processing etc.

In an exemplary embodiment, the customized extension 40 may be made of a soft material, e.g. having a Shore A hardness of at most 30 or 40. In other embodiments, the customized extension 40 may be made of a hard material such as titanium, acrylic, polyurethane or any other material suitable for eartips.

The described procedure allows for embedding the skeleton device 1 into the ear impression 20, which then allows the optimal orientation of the real housing 30 of the concha worn device and the customized extension 40.

In contrast to a traditional coupling of a hearable or hearing instrument to the ear canal 14 by a dome, the described process may provide a retention lock at the first bend 15 of the ear canal 14. Increased retention of the device may supersede additional retention structures such as fingers or fins attached to the housing 30. In other embodiments, the described process may provide a retention lock at other features of the ear aside from the first bend 15, depending on the device shape. For example, the customized extension may be shorter and not extend beyond the first bend 15.

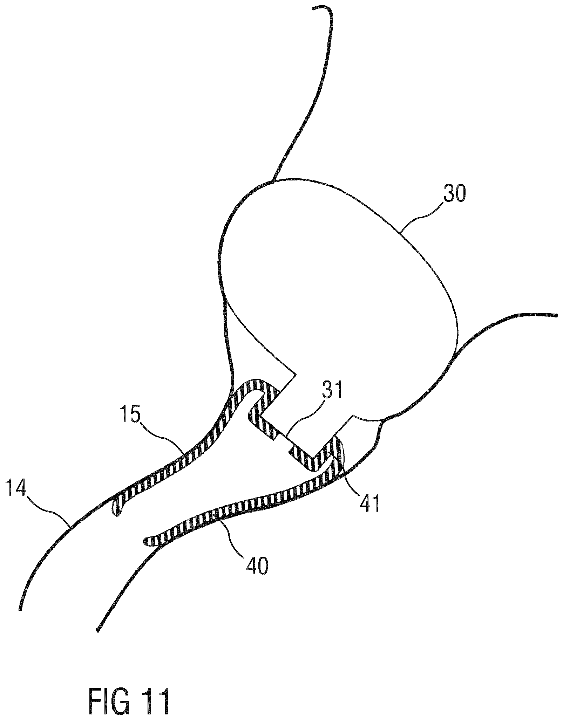

**Figure 11** is a schematic view of the real housing 30 of the concha worn device with the spout 31 pointing into the ear canal 14 of the user's ear 10, wherein the customized extension 40 is coupled with its connector 41 to the spout 31. The spout 31 may have a circular or oval cross section allowing the customized extension 40 to align itself in the ear canal 14 when inserted by rotating about the spout 31.

The described process allows the customized extension 40 to match the actual shape of the ear canal 14 with the inserted concha worn device, whereas a non-custom dome can be misaligned with the ear canal 14 due to physical constraints of the real housing 30 in the concha 11, thereby causing pressure points in the ear canal 14 and discomfort as a result as well as inadequate fit and/or retention and/or hold in the ear. With the non-custom dome, pressure points cannot only occur in the ear canal 14, but also in the concha 11 by the device.

A customized extension 40 allows for a larger sealing zone with basically no variability in acoustic sealing. This makes the acoustic performance of a hearable or hearing instrument more robust.

The visible part of the concha worn device, i.e. the real housing 30, can be placed where intended rather than being forced to a protruding position due to the constraint of the coupling in the ear canal 14.

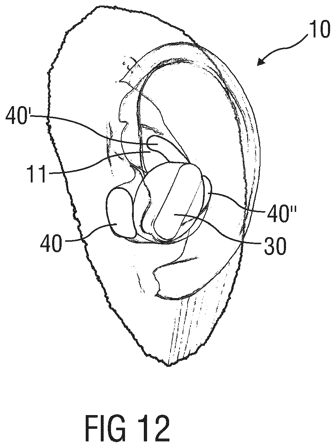

**Figure 12** is a schematic view of a concha worn device arranged in a concha 11 of an ear 10. The concha worn device comprises a housing 30 with a customized extension 40, e.g. a custom ear tip to resemble the shape of the ear canal portion of the ear impression and to comprise a connector positioned and oriented to couple to the spout. Figure 12 further shows another customized extension 40' which may alternatively or additionally be provided on the housing 30 and which may be produced by the above described method. Extension 40' is an ear fin to fit into the cavum cymba portion of the ear. Figure 12 further shows another customized extension 40" which may alternatively or additionally be provided on the housing 30 and which may be produced by the above described method. Extension 40" is an extension of a standard device to fit anywhere in-between the housing 30 of the device and the ear skin surface.

The figures explained above mainly show the skeleton housing 1 provided for the left ear 10 of a user. It goes without saying that alternatively or additionally, a mirrorinverted skeleton housing 1 may be provided for the right ear and be applied in the same way to produce a customized extension 40 for the right ear.

### List of References

- 1: skeleton housing
- 2: lateral opening
- 3: medial opening
- 10: ear
- 11: concha
- 12: tragus
- 13: antitragus
- 14: ear canal
- 15: first bend
- 16: position
- 20: ear impression
- 21: ear canal portion
- 22: housing portion
- 30: housing
- 31: spout
- 40, 40', 40": customized extension, custom ear tip
- 41: connector
- 53: foam block

## Claims

1. A skeleton housing (1) for taking an ear impression (20) of a part of an ear canal (14) and/ or of at least a part of a concha (11) of a human ear (10), the skeleton housing (1) having a shape fitting into a concha (11) of the ear (10), the skeleton housing (1) comprising a hollow permeable shell permitting a viscous impression material to flow through, the skeleton housing (1) comprising a medial opening (3) positioned to face toward or into the ear canal (14) when the skeleton housing (1) is inserted in the concha (11).

2. The skeleton housing (1) of claim 1, wherein the hollow shell is configured as a grid or basket having loops or openings or is made from a permeable material.

3. The skeleton housing (1) of claim 1 or 2, further comprising a lateral opening (2) positioned to face in a lateral direction.

4. The skeleton housing (1) according to any one of the preceding claims, wherein the lateral opening (2) and/or the medial opening (3) are/is larger than any other openings in the permeable shell.

5. The skeleton housing (1) according to any one of the preceding claims, shaped to slightly deform the concha (11) when inserted therein.

6. The skeleton housing (1) according to any one of the preceding claims, a shape of the skeleton housing (1) resembling the shape of a housing (30) of a concha worn device such as a hearing device having a spout (31) fitting into the medial opening (3) of the skeleton housing (1).

7. The skeleton housing (1) according to any one of the preceding claims, wherein the hollow shell is configured to be permeable at least almost entirely or only adjacent the medial opening (3) and has a closed surface otherwise except for the lateral and/or medial openings (2, 3).

8. A method of producing an ear impression (20) using a skeleton housing (1), in particular the skeleton housing (1) according to any one of the preceding claims, comprising the steps of:
A) inserting the skeleton housing (1) into a concha (11) of a human ear (10) such that a medial opening (3) of the skeleton housing (1) faces toward or into an ear canal (14) of the ear (10),
B) injecting an impression material into the ear canal (14),
wherein after performing the steps A and B the skeleton housing (1) is at least partially embedded in the impression material,
the method further comprising the steps
C) curing of the impression material to form the ear impression (20) at least partially embedding the skeleton housing (1), the ear impression (20) comprising an ear canal portion (21) and a housing portion (22) at least partially embedding the skeleton housing (1),
D) removing the ear impression (20) including the skeleton housing (1) from the ear (10).

9. The method of claim 8 wherein step A is performed before step B and injecting the impression material is carried out through a lateral opening (2) of the skeleton housing (1) into the skeleton housing (1), wherein the impression material flows through the medial opening (3) and the adjacent permeable shell, or wherein injecting the impression material is carried out through the lateral opening (2) and the medial opening (3).

10. The method of claim 8 wherein step B is performed before step A.

11. The method according to any one of the claims 8 to 10, wherein the ear canal (14) is filled with the impression material beyond the first bend (15).

12. A method of producing a customized extension (40) such as an ear tip (40) configured to be coupled to a housing (30) of a concha worn device such as a hearing device, the housing (30) having a shape fitting into a concha (11) of a human ear (10), the customized extension (40) having a shape fitting into an ear canal (14) of the ear (10), the method including the method according to any one of claims 8 to 11 and further comprising the steps of:
- 3D-scanning the ear impression (20) with the embedded skeleton housing (1),
- registering the 3D-scanned ear impression (20) and the embedded skeleton housing (1) with a 3D geometry of the housing (30) having a spout (31) in a modelling software, such that the spout (31) is registered with the medial opening (3),
- modelling the customized extension (40) to resemble the shape of the ear canal portion (21) of the ear impression (20) and to comprise a connector (41) positioned and oriented to couple to the spout (31).

13. The method according to claim 12, wherein the customized extension (40) is made of a soft material having a Shore A hardness of at most 30 or 40.

14. The method according to claim 12, wherein the customized extension (40) is made of a hard material such as titanium, acrylic or polyurethane

15. A hearing device comprising a housing (30) with a spout (31) and a customized extension (40) according to any one of claims 12 to 14 coupled to the spout (31).
